Europäisches Patentamt

European Patent Office

Office européen des brevets

(11) Veröffentlichungsnummer: **0 236 789**
**A1**

(12) **EUROPÄISCHE PATENTANMELDUNG**

(21) Anmeldenummer: **87102152.3**

(22) Anmeldetag: **16.02.87**

(51) Int. Cl.⁴: **G01N 24/06**

(30) Priorität: **28.02.86 DE 3606643**

(43) Veröffentlichungstag der Anmeldung:
**16.09.87 Patentblatt 87/38**

(84) Benannte Vertragsstaaten:
**DE FR GB NL**

(71) Anmelder: **Siemens Aktiengesellschaft Berlin und München**
**Wittelsbacherplatz 2**
**D-8000 München 2(DE)**

(72) Erfinder: **Frese, Georg Dipl.-Phys**
**Friedrich-Bauer-Str. 7**
**D-8520 Erlangen(DE)**
Erfinder: **Pausch, Günter**
**Peter-Vischer-Ring 11**
**D-8521 Effeltrich(DE)**

(54) **Nichtorthogonales Shim-Spulensystem zur Korrektur von Magnetfeldinhomogenitäten in Kernspinresonanzgeräten.**

(57) Die Erfindung betrifft ein Shim-Spulensystem für die Korrektur von Magnetfeldinhomogenitäten, wie es z.B. in der spektroskopischen oder bildgebenden Kernspinresonanz verwendet wird. Einzelne, nicht überlappende und getrennt ansteuerbare Shim-Spulen (1 bis 8) erzeugen Korrekturfelder, denen linear unabhängige, aber nicht notwendigerweise orthogonale Spektralvektoren zugeordnet werden können. Durch geeignete Ansteuerung der Einzelspulen (1 bis 8) kann somit jeder Spektralvektor, welcher zur Korrektur der Inhomogenitäten erforderlich ist, eindeutig erzeugt werden. Das erfindungsgemäße Shim-Spulensystem ist sowohl bezüglich des Materialaufwandes als auch bezüglich der zum Betrieb notwendigen Energie ökonomischer.

EP 0 236 789 A1

## Nichtorthogonales Shim-Spulensystem zur Korrektur von Magnetfeldinhomogenitäten in Kernspinresonanzgeräten

Die Erfindung betrifft ein Shim-Spulensystem für die Korrektur von Magnetfeldinhomogenitäten.

In der spektroskopischen oder bildgebenden Kernspinresonanz werden häufig magnetische Grundfelder mit sehr guter Homogenität benötigt. Zur Homogenisierung der magnetischen Felder von Permanent-, Elektromagneten oder supraleitenden Magneten können in Kernspinresonanzgeräten stromdurchflossene Shim-Spulen verwendet werden, die über das durch sie erzeugte zusätzliche Magnetfeld den für die Homogenisierung erforderlichen Korrekturbeitrag liefern.

Für die Behandlung dieses Problems ist es zweckmäßig, die Feldverteilung des Magnetfeldes in sphärischen Polarkoordinaten $(r, \theta, \phi)$ zu beschreiben. Dabei wird die Polarachse ($\theta$ = Null) in die Richtung des Grundfeldes gelegt. Ein für manche Zwecke günstiges kartesisches Korrdinatensystem (x, y, z) wird so gelegt, daß die z-Achse ebenfalls in die Grundfeldrichtung zeigt.

Der räumliche Verlauf der z-Komponente des magnetischen Grundfeldes ($B_z$) kann dargestellt werden durch die Entwicklung dieser Größe nach dem Satz der orthogonalen Kugelfunktionen. Beschränkt man sich auf Felder, die keine $\phi$ -Abhängigkeit aufweisen, so genügt die zonale Entwicklung:

$$B_z(r, \theta) = \sum_{n=0}^{\infty} r^n A_n P_n(\cos \theta)$$

Durch die Angabe eines Spektralvektors, d.h. eines Satzes von Spektralkoeffizienten $A_n$ (n = 0 bis $\infty$) ist somit die räumliche $B_z$-Verteilung eindeutig bestimmt.

In der Praxis reicht es im allgemeinen aus, sich auf einen Entwicklungsgrad von n < 9 zu beschränken, so daß jede $B_z$-Verteilung durch die Angabe eines Spektralvektors ($A_0$, $A_1$, ..., $A_7$, $A_8$) charakterisiert werden kann.

Shim-Spulensysteme zur Korrektur von Magnetfeldinhomogenitäten sind z.B. in den US-Patentschriften 3 622 869 und 3 569 823 beschrieben worden. Diese Anordnungen arbeiten nach dem Prinzip eines zonalen orthogonalen Spulensystems, d.h. sie sind aus einer Vielzahl von Spulensätzen aufgebaut, bei der jeder Spulensatz möglichst nur eine Spektralkomponente erzeugt. Durch eine Linearkombination dieser Spulensätze läßt sich somit jedes gewünschte Korrekturspektrum erzeugen.

Faßt man mehrere orthogonale Spulensätze zu einer Korrekturanordnung zusammen, so muß wegen der endlichen Leiterdicke und der nötigen Amperewindungszahlen eine Anordnung in mehreren Wicklungslagen mit zum Teil erheblichen Überlappungen einzelner Spulen in Kauf genommen werden.

Abhängig von den zu korrigierenden Feldinhomogenitäten werden diese Spulenüberlappungen oft von entgegengesetzten Strömen durchflossen und heben sich somit in ihrer Wirkung auf. Das System ist deshalb sowohl bezüglich des Materialaufwandes als auch bezüglich der notwendigen elektrischen Energie unökonomisch.

Der Erfindung liegt die Aufgabe zugrunde, ein Spulensystem zur Korrektur von Magnetfeldinhomogenitäten zu entwickeln, dessen Materialaufwand und Energieverbrauch bei vergleichbarer Wirkung wesentlich geringer ist als bei einem orthogonalen Spulensystem.

Die Aufgabe ist erfindungsgemäß dadurch gelöst, daß auf die für orthogonale Spulensysteme erstrebenswerte Bildung von Spulensätzen, die jeweils nur eine Spektralkomponente erzeugen, verzichtet wird und statt dessen eine Anordnung von getrennt ansteuerbaren und nicht überlappenden Einzelspulen benutzt wird, wobei die Einzelspulen Felder erzeugen, deren zugeordnete Spektralvektoren linear unabhängig, aber nicht notwendigerweise orthogonal sind.

Durch das erfindungsgemäße Spulensystem werden sowohl der Materialaufwand (Zahl der Spulen) als auch die von der Gesamtanordnung aufgenommene Leistung im Vergleich zu einem orthogonalem Spulensystem erheblich reduziert. Die lineare Unabhängigkeit der Spektralvektoren der Einzelspulen gewährleistet, daß durch Linearkombination der Vektoren jedes erforderliche Korrekturspektrum erzeugt werden kann.

Ziel der Methode ist es, mit den Einzelspulen ein Korrekturfeld zu erzeugen, dessen $B_z$-Komponente durch den Spektralvektor K = $(0, -A_1, -A_2, ..., -A_7, -A_8)$ charakterisiert werden kann, wobei der Vektor A = -($A_0$, $A_1$, ..., $A_7$, $A_8$) das durch die Grundfeldmagnete erzeugte Grundfeld repräsentiert (Die Spektralkomponente $A_0$ entspricht dem ortsunabhängigen homogenen Ideal-Grundfeld). Es genügt hierzu, im Prinzip acht Einzelspulen zu wählen, deren Spektralvektoren $S_j$ linear unabhängig sind. Die Gleichung

$$K = \sum_{j=1}^{8} I_j S_j$$

oder in Komponenten $K_i = \sum_{j=1}^{8} S_{ij} I_j$    (i = 1 bis 8)

ist dann bezüglich der acht unbekannten Stromwerte $I_j$ eindeutig lösbar.

Der achtdimensionale Vektorraum der Spektralvektoren läßt sich in bekannter Weise in zwei echte Teilräume zerlegen. Ein Teilraum U wird durch die geraden (zonalen) Kugelfunktionen $r^2 P_2$, $r^4 P_4$, $r^6 P_6$ und $r^8 P_8$ aufgespannt, während der andere Teilraum V die ungeraden zonalen Kugelfunktionen $r P_1$, $r^3 P_3$, $r^5 P_5$ und $r^7 P_7$ als Basis enthält. Beide Teilräume sind orthogonal zueinander, d.h. jeder beliebige Spektralvektor aus U steht senkrecht auf jeden beliebigen Spektralvektor aus V. Ein Spektralvektor aus dem Teilraum U wird z.B. durch ein Spulenpaar erzeugt, bei dem die beiden Spulen koaxial mit der z-Achse und symmetrisch zur z = 0-Ebene angeordnet sind und mit Erregerstrom gleichsinnig durchflossen werden. Werden die Spulen bei sonst gleicher Anordnung vom Erregerstrom ungleichsinnig durchflossen, so wird ein Feld entsprechend einem Spektralvektor aus V erzeugt. Da in dem erfindungsgemäßen Spulensystem jede Einzelspule getrennt von den anderen ansteuerbar ist, ist es möglich, mit einem Spulenpaar sowohl gerade (durch gleichsinnige Ansteuerung) als auch ungerade (durch ungleichsinnige Ansteuerung) Spektralkomponenten zu erzeugen.

Um das Grundfeld zu homogenisieren, ist die Anordnung der Einzelspulen, die Spulengeometrien (Positionen, Wickeldicken und -höhen, Windungszahl) sowie Spulenströme so zu optimieren, daß möglichst viele Spektralkomponenten der Störungen eliminiert werden. Dies kann sowohl mit Hilfe analytischer als auch numerischer Methoden erfolgen.

Nicht vernachlässigbare Spektralkomponenten der Grundfeldstörung von hohem Entwicklungsgrad sind im allgemeinen gerade. Die ungeraden Spektralkomponenten von hohem Entwicklungsgrad sind dagegen meist klein. In diesem Fall wird man bestrebt sein, die Anordnung der Einzelspulen so zu wählen, daß eine möglichst genaue, gerade Spektralkomponente hohen Entwicklingsgrades (2n) erzeugt und somit die Realisierung von Korrekturfeldern bis zum Grade 2n + 1 möglich wird.

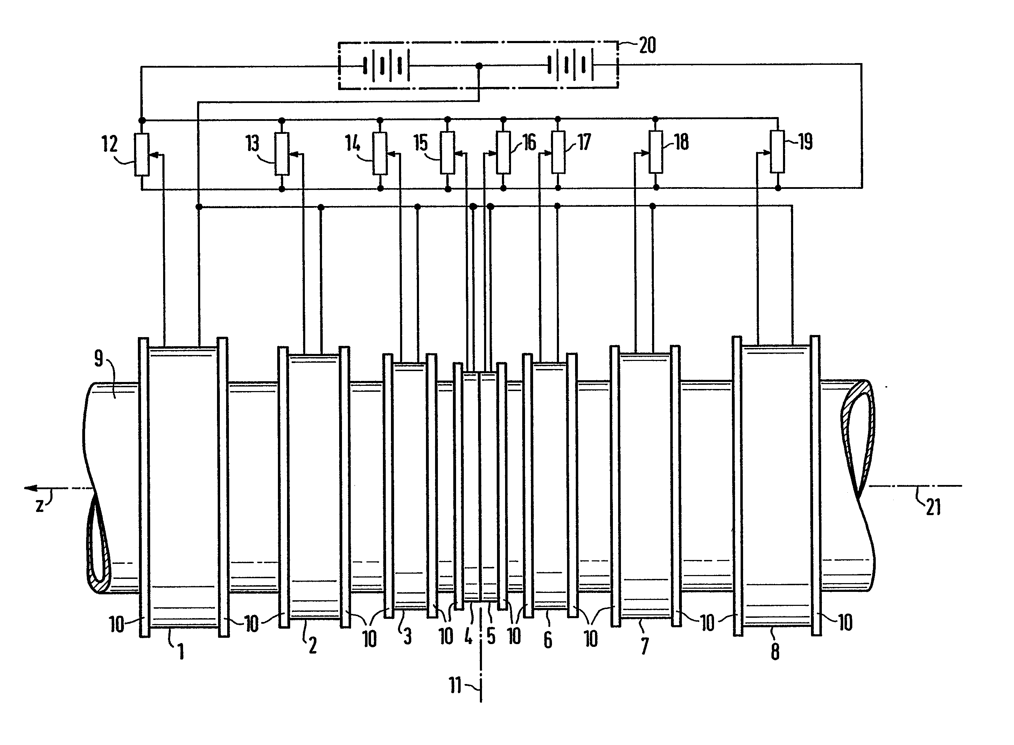

Die Erfindung ist nachstehend anhand der Zeichnung und eines Ausführungsbeispieles näher erläutert.

Die Figur zeigt acht Einzelspulen (1 bis 8), die auf einen Zylinder aus Glasfiber 9 gewickelt sind, wobei die Zylinderachse 21 koaxial zur z-Achse gewählt ist. Die Spulenwindungen jeder Spule werden seitlich durch Stege 10 aus Kunststoff eingefaßt. Die Anordnung der Spulenkörper ist spiegelsymmetrisch zur z-0-Ebene 11. Jede Spule wird getrennt von den anderen über ein eigenes Potentiometer (12 bis 19) angesteuert, wobei die Stromversorgung durch eine symmetrische Spannungsquelle 20 erfolgt. Die Ansteuerung kann jedoch ebenfalls durch acht getrennte, je einer Einzelspule zugeordneten regelbaren Spannungsquellen durchgeführt werden.

Versucht man durch Lösen des linearen Gleichungssystems die acht Spulenströme zu errechnen, erhält man im allgemeinen extrem große Stromwerte, da die Daten bei dieser Methode nicht hinsichtlich ihrer Bedeutung gewichtet werden. Es müssen außerdem fertigungstechnische Erfordernisse berücksichtigt werden. Um die in der Praxis auftretenden Störspektren mit realistischen Stromwerten korrigieren zu können, kann die Wahl eines geeigneten mathematischen Algorithmus (z.B. eine Transformation auf andere Basisvektoren) dieses Problem umgehen. Aus den erwähnten fertigungstechnischen Gründen wird man die notwendigen Amperewindungszahlen und damit verbundenen Spulenabmessungen nach der voraussichtlichen Bandbreite der Feldstörungen festlegen.

Das beschriebene Shim-System ist in supraleitender Ausführung besonders vorteilhaft, da die Korrekturspulen wegen des dann geringen Wickel- und Materialaufwandes z.B. auf den vorhandenen Spulenkörpern für die Erzeugung des Grundfeldes aufgebracht werden können. Außer dem dadurch erzielten Platzgewinn sind das Fehlen der elektrischen Verlustleistung und damit die Reduktion der Instabilitäten der Shim-Spulen-Stromversorgung besonders hervorzuheben.

**Ansprüche**

1. Vorrichtung zur Homogenisierung eines magnetischen Grundfeldes in einem Kernspinresonanzgerät mit Spulen (1 bis 8) zur Erzeugung des für die Homogenisierung notwendigen Korrekturfeldes, **dadurch gekennnzeichnet,** daß eine Anordnung von getrennt ansteuerbaren und nicht überlappenden Einzelspulen (1 bis 8) benutzt wird, wobei die Einzelspulen Korrekturfelder erzeugen, deren zugeordnete Spektralvektoren linear unabhängig, aber nicht notwendigerweise orthogonal sind.

2. Vorrichtung nach Anspruch 1, **dadurch gekennzeichnet,** daß die Lage der Spulen (1 bis 8) auf einem geeigneten Trägerkörper (9) so optimiert ist, daß ein reiner Spektralkoeffizient möglichst hohen und geraden Entwicklungsgrades 2n erzeugt und somit die Realisierung von Korrekturfeldern bis zum Grade 2n + 1 ermöglicht wird.

3. Vorrichtung nach Anspruch 1 oder 2, **dadurch gekennzeichnet,** daß die Spulen in Paaren (1 und 8, 2 und 7, 3 und 6, 4 und 5) angeordnet sind, wobei die Spulen eines Paares symmetrisch zur z = 0-Ebene - (11) liegen.

4. Vorrichtung nach den Ansprüchen 1 bis 3, **dadurch gekennzeichnet,** daß die Spulenachsen der Spulen (1 bis 8) parallel zur Grundfeldrichtung verlaufen.

5. Vorrichtung nach den Ansprüchen 1 bis 4, **dadurch gekennzeichnet,** daß die Spulen (1 bis 8) oder zumindest einige der Spulen (1 bis 8) supraleitend sind.

Europäisches
Patentamt

**EUROPÄISCHER RECHERCHENBERICHT**

Nummer der Anmeldung

EP 87 10 2152

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 152 554 (GENERAL ELECTRIC CO.)<br>* Seite 5, Zeile 15 - Seite 11, Zeile 19 * | 1-5 | G 01 N 24/06 |
| A | GB-A-2 070 254 (THE OXFORD INSTRUMENTS GROUP LTD)<br>* Seite 2, Zeile 64 - Seite 3, Zeile 41; Seite 5, Zeile 47 - Seite 8, Zeile 15 * | 2-5 | |
| A | GB-A-2 158 248 (YOKOGAWA HOKUSHIN ELECTRIC CORP.)<br>* Seite 1, Zeile 60 - Seite 4, Zeile 34 * | 2-5 | |
| A | EP-A-0 162 369 (GENERAL ELECTRIC CO.)<br>* Seite 10, Zeile 29 - Seite 14, Zeile 15 * | 1-5 | RECHERCHIERTE SACHGEBIETE (Int. Cl.4) |
| A | PATENT ABSTRACTS OF JAPAN, Band 9, Nr. 321 (E-367)[2044], 17. Dezember 1985; & JP-A-60 153 111 (NIPPON DENSHI K.K.) 12-08-1985<br>--- -/- | 1-5 | G 01 N 24/00 |

Der vorliegende Recherchenbericht wurde für alle Patentansprüche erstellt.

| Recherchenort | Abschlußdatum der Recherche | Prüfer |
|---|---|---|
| DEN HAAG | 16-06-1987 | DIOT P.M.L. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | MAGNETIC RESONANCE IN MEDICINE, Band 1, 1984, Seiten 44-65, Academic Press Inc., New York, US; F. ROMEO et al.: "Magnet field profiling: analysis and correcting coil design" * Seiten 51-55, Abschnitt; "Zonal correcting systems" *  ---  | 2-5 | |
| P,X | EP-A-0 200 891 (SPECTROSPIN AG) * Spalte 6, Zeile 30 - Spalte 7, Zeile 29 *  ----- | 1-5 | |
| | | | RECHERCHIERTE SACHGEBIETE (Int. Cl.4) |

Der vorliegende Recherchenbericht wurde für alle Patentansprüche erstellt.

| Recherchenort | Abschlußdatum der Recherche | Prüfer |
|---|---|---|
| DEN HAAG | 16-06-1987 | DIOT P.M.L. |